Europäisches Patentamt

European Patent Office

Office européen des brevets

(19)

(11) Veröffentlichungsnummer : **0 225 337**
**B1**

(12) **EUROPÄISCHE PATENTSCHRIFT**

(45) Veröffentlichungstag der Patentschrift :
**20.09.89**

(21) Anmeldenummer : **86902785.4**

(22) Anmeldetag : **20.05.86**

(86) Internationale Anmeldenummer :
**PCT/CH 86/00066**

(87) Internationale Veröffentlichungsnummer :
**WO/8607160 (04.12.86 Gazette 86/26)**

(51) Int. Cl.$^4$ : **G 01 R 31/08**

(54) VORRICHTUNG ZUR DETEKTION VON KORONAENTLADUNGEN AUF WECHSELSTROM-FREILEITUNGEN.

(30) Priorität : **21.05.85 CH 2156/85**

(43) Veröffentlichungstag der Anmeldung :
**16.06.87 Patentblatt 87/25**

(45) Bekanntmachung des Hinweises auf die Patenterteilung : **20.09.89 Patentblatt 89/38**

(84) Benannte Vertragsstaaten :
**AT BE CH DE FR GB IT LI NL SE**

(56) Entgegenhaltungen :
**US–A– 3 820 018**
**US–A– 4 006 410**
**US–A– 4 439 723**

(73) Patentinhaber : **KORONA MESSTECHNIK GOSSAU**
**St. Galler Strasse 23**
**CH-9202 Gossau (CH)**

(72) Erfinder : **KOSINA, Bohumil**
**Zeughausstrasse 6**
**CH-9202 Gossau (CH)**
Erfinder : **HUBACHER, Peter**
**Sonnenhaldenstrasse 21**
**CH-9032 Engelburg (CH)**
Erfinder : **TALACKO, Radovan**
**Sturzeneggstrasse 19**
**CH-9015 St. Gallen (CH)**

(74) Vertreter : **Scheidegger, Zwicky, Werner & Co.**
**Stampfenbachstrasse 48 Postfach**
**CH-8023 Zürich (CH)**

**Beschreibung**

Die Erfindung betrifft eine Kontrollvorrichtung zur elektronischen Detektion von bei Wechselstrom-Freileitungen vorkommenden Fehlstellen, an denen Energieverluste durch Koronaentladungen auftreten.

Bei elektrischen Freileitungen, insbesondere Hochspsnnungs-Freileitungen, können schon verhältnismässig geringfügige Schäden an den Leitern, Isolatoren und Erdungen zu beachtlichen Stromverlusten führen. Von besonderer Bedeutung jedoch ist, dass solche Schäden zum Grösserwerden tendieren und zur Ursache von Kurzschlüssen werden können, die eine Abschaltung des betroffenen Netzteiles auslösen und unter Umständen gar noch grössere und nur mit einem entsprechenden Aufwand reparable Schäden im Netz zur Folgen haben. Für einen zuverlässigen Betrieb ist es daher erforderlich, den Zustand von Freileitungen unter Kontrolle zu haben und auftretende Fehlstellen möglichst schon in einem Frühstadium zu erkennen, so dass sie rechtzeitig und noch mit geringem Aufwand behoben werden können, bevor sich aus ihnen grössere Schäden für das Netz entwickeln.

Die Ueberprüfung von Freileitungen wird im allgemeinen von Fachleuten vorgenommen, die periodisch entlang den Freileitungen fahren oder gehen und temporär abgeschaltete Leitungsstrecken visuell auf Fehlstellen kontrollieren, wobei meist ein Besteigen von Hochspannungsmasten nicht zu umgehen ist. Eine solche Ueberwachung von Freileitungen ist nicht nur zeit- und kostenaufwendig, sondern stellt auch erhöhte Anforderungen an die Kontrolleure, die sowohl über eine ausreichende körperliche Konstitution wie auch über eine genügende fachliche Erfahrung verfügen müssen. Dabei kann jedoch nicht ausgeschlossen werden, dass bei noch so sorgfältiger und gewissenhafter Kontrolle wenig ausgeprägte Fehlstellen übersehen werden und es in der Folge zu grösseren Netzschäden kommen kann.

Man hat daher schon lange versucht, dieses anspruchsvolle und unwirtschaftliche visuelle Kontrollverfahren abzulösen und durch andere Verfahren zu ersetzen, welche die Detektion von Fehlstellen in Wechselstrom-Freileitungsnetzen aus Distanz bei eingeschaltet belassener Freileitung wesentlich schneller und zuverlässiger gestatten und überdies eine sichere Netzüberwachung mit weniger und vor allem auch nicht so hohen Anforderungen unterstellten Kontrolleuren erlauben.

Die Erkenntnis, dass Leitungs-, Verbindungs- und Isolationsdefekte örtliche Erhitzungen der betreffenden Anlageteile bewirken, hat Anlass gegeben, die kritischen Stellen von Freileitungen thermographisch aufzunehmen. Auch dieses Kontrollverfahren ist verhältnismässig aufwendig.

Ferner hat man erkannt, dass die relevanten Fehlstellen von Freileitungen solche sind, bei denen Stromverluste durch Entladungen, insbesondere Koronaentladungen, erfolgen, welche elektromegnetische Strahlungsquellen sind, deren Frequenzen wesentlich höher als die Netzfrequenz sind und in keinem harmonischen Verhältnis zur Netzfrequenz stehen. Diese Feststellung hat zu einem elektronischen Ueberwachungsverfahren geführt, bei welchem das elektromagnetische Feld entlang der Freileitung mittels einer Antenne, einer Verstärkereinrichtung und eines Oszilloskops auf Unregelmässigkeiten überprüft wird. Eine Einrichtung dieser Art, die die im Oberbegriff des Anspruchs 1 aufgeführten Merkmale aufweist, ist durch die US-Patentschrift 4 006 410 bekannt geworden. In dieser bekannten Einrichtung werden die mittels der Antenne empfangenen hochfrequenten Signale durch Modulation mit einem internen Signal variabler Frequenz und mit Hilfe von Bandfiltern und Wellenfallen nach Fourier analysiert. Hierfür ist ein relativ grosser technischer Aufwand erforderlich, was beträchtliche Kosten verursacht und zu erhöhter Störungsanfälligkeit der Einrichtung Anlass gibt.

Die vorliegende Erfindung hat nun zum Ziel, eine technisch einfachere und weniger störungsanfällige Kontrollvorrichtung für die elektronische Detektion von Fehlstellen an Freileitungen zu schaffen.

Die gestellte Aufgabe ist erfindungsgemäss durch die Schaffung der in Anspruch 1 definierten elektronischen Kontrollvorrichtung gelöst. Bei der erfindungsgemässen Kontrollvorrichtung, die eine Antenne, eine Verstärkereinrichtung und ein Oszilloskop umfasst, ist die Verstärkereinrichtung für eine Breitbandverstärkung der mittels der Antenne empfangenen Signale in einem Frequenzband von einer unterhalb der niederfrequenten Netz-Wechselstromfrequenz liegenden unteren Grenzfrequenz bis hinauf zu einer mindestens 20 kHz betragenden, vorzugsweise zwischen 200 MHz und etwa 1 GHz liegenden, oberen Grenzfrequenz ausgebildet, wobei im Bereich zwischen der unteren Grenzfrequenz und etwa 10 kHz die Verstärkung reduziert ist. Das gesamte Frequenzspektrum der Ausgangssignale der Verstärkereinrichtung ist an eine Eingangsschaltung des Oszilloskops für Vertikal- und Horizontalablenkungen des Bildpunktes geführt, so dass auf einem Bildschirm des Oszilloskops ein von der sinusförmigen Netz-Wechselspannung auf der Freileitung erzeugtes niederfrequentes Signal als eine glatte geschlossene Kurve und durch Koronaentladungen verursachte hochfrequente Signale als Störungen der geschlossenen Kurve dargestellt werden. Erscheinungsform, Stärke und Lage der Störungen auf der geschlossenen Kurve sind charakteristisch für den Ort und die Art einer Fehlstelle der Freileitung.

Die mit der Erfindung erzielten Vorteile bestehen insbesondere darin, dass die Kontrollvorrichtung technisch relativ einfach, preisgünstig und wenig störungsanfällig ist. Da die Kontrollvorrichtung lediglich eine Breitband-Verstärkereinrichtung und keinen Frequenzanalysator aufweist, erlaubt sie den Bau eines einfach zu handhabenden, stets einsatzbereiten und verhältnismässig leichten Gerätes, das auch dann, wenn es mit einer eigenen Betriebsstromversorgung, wie Batterien, ausgerüstet ist, von einer Person mitgeführt werden kann und so eine Ueberwachung vom Boden durch Abgehen oder Abfahren, aber auch insbesondere aus der Luft durch Abfliegen der Fernleitung mit einem Hubschrauber gestattet, so dass die Freileitungsüberwachungen jeweils unter Berücksichtigung der gegebenen Umstände, wie Streckenlänge, Geländebeschaffenheit, Häufigkeit der vorzunehmenden Kontrollen und Wetterprognosen allein im Hinblick auf optimale Wirtschaftlichkeit organisiert werden können.

Die Lokalisierung von Fehlstellen und die Bestimmung der Fehlstellenart, wie mechanische Beschädigung, Korrosion, Verschmutzung, Luftblasen, Ueberhitzung usw., erfolgt durch visuelles Beobachten der auf dem Oszilloskop-Bildschirm ersichtlichen Figur, die für eine ideal intakte Freileitung eine glatte geschlossene Kurve ist, wogegen das Vorhandensein einer Fehlstelle in der Freileitung sich als eine beispielsweise zeckenartige Störung dieser glatten Kurve in einer für die betreffende Fehlstellenart charakteristischen Erscheinungsform manifestiert. Die vorkommenden Fehlstellenarten und zugehörigen charakteristischen Störungsformen können in einem Katalog zusammengestellt sein, so dass die Bestimmung der Fehlstellenarten auf ein Vergleichen reduziert ist und der Kontrolleur nicht über eine einschlägige Erfahrung zu verfügen braucht, sondern lediglich mit der Bedienung der Kontrollvorrichtung, d. h. im wesentlichen mit der Bedienung eines Oszilloskops, vertraut sein muss. Die Amplituden der bei Fehlstellen auf dem Oszilloskop-Bildschirm ersichtlichen Störungen sind von der Stärke der an den Fehlstellen stattfindenden elektrischen Entladungen abhängig, und durch Vermessen der Störungsamplituden kann, zumindest im Groben, Auskunft über die Beschaffenheit einer ermittelten Fehlstelle erhalten werden. Diese Bestimmung von Fehlstellen nach Ort, Art und Beschaffenheit kann sofort, beispielsweise während eines Ueberwachungsfluges, vorgenommen werden.

Die erfindungsgemässe Kontrollvorrichtung gestattet aber auch, ohne Schwierigkeiten die während eines Ueberwachungsfluges bei Fehlstellen am Oszilloskop-Bildschirm ersichtlichen Figuren unter z. B. mittels eines Mastenzählers erfolgender Zuordnung zum betroffenen Leitungsort zu speichern, z. B. auf einem photographischen Film, und die gespeicherten Figuren nachher in einer Bodenstation auszuwerten. Abgesehen von einer für die Instandsetzungsarbeiten nützlichen Dokumentation der aufgefundenen Fehlstellen erbringt eine solche Speicherung zusätzliche Vorteile insofern, als auch für kürzeste Ueberwachungszeiten ein in der Fehlstellenbestimmung vollkommen ungeübter Kontrolleur eingesetzt werden kann und zudem die Möglichkeit von Fehlern in der Fehlstellenerfassung und Fehlstellenbeurteilung, die gegenüber der herkömmlichen subjektiven, optischen Kontrolle allein schon durch die Verwendung eines elektronischen Gerätes weitgehendst eingeschränkt ist, noch weiter ausgeschlossen wird. Schliesslich wird durch die erfindungsgemässe Kontrollvorrichtung die Freileitungsüberwachung auch für den Kontrolleur sicherer und vor allem weniger strapaziös, da keine Leitungsmasten bestiegen werden müssen und die Kontrolle zwar bei angeschalteter Freileitung, doch mit genügendem Sicherheitsabstand von dieser, vom Boden oder aus der Luft in einer Flughöhe von z. B. 30 m über der Freileitung erfolgt.

Vorteilhafte Ausbildungen der Erfindung sind in den abhängigen Ansprüchen angegeben.

Im folgenden wird die Erfindung rein beispielsweise unter Bezugnahme auf die beiliegenden Zeichnungen näher erläutert. In den Zeichnungen zeigen :

Fig. 1 ein schematisches Blockschaltbild eines bevorzugten Ausführungsbeispiels der Kontrollvorrichtung nach der Erfindung ;

Fig. 2 ein Schaltbild der in der Kontrollvorrichtung verwendeten bevorzugten Verstärkereinrichtung ;

Fig. 3 eine Verstärkungskennlinie der Verstärkereinrichtung gemäss Fig. 2 ;

Fig. 4 den zeitlichen Verlauf eines von der Netzwechselspannung herrührenden Signals und eines überlagerten, von einer Fehlstelle verursachten hochfrequenten Signals ;

Fig. 5 ein bei einer Fehlstelle in der Freileitung auf dem Bildschirm der Kontrollvorrichtung ersichtliches Oszillogramm mit einer glatten geschlossenen Kurve entsprechend der Netzwechselspannung und einer überlagerten Störung entsprechend den an der Fehlstelle auftretenden elektrischen Entladungen ;

Fig. 6 ein ähnliches Oszillogramm für den Fall einer an einem Isolator der Freileitung auftretenden Koronaentladung ;

Fig. 7 ein Oszillogramm für den Fall eines korrodierten Teiles der Freileitung als Fehlstelle ;

Fig. 8 ein Oszillogramm für den Fall eines mechanisch beschädigten Teiles der Freileitung als Fehlstelle ;

Fig. 9 ein Oszillogramm für den Fall eines Kurzschlusses in der Freileitung ;

Fig. 10 eine perspektivische Vorderansicht eines Gerätes, welches wesentliche Teile der in Fig. 1 gezeigten Kontrollvorrichtung umfasst und insbesondere für die Ueberprüfung von Freileitungen aus einem Hubschrauber geeignet ist ;

Fig. 11 eine analoge Rückansicht des gleichen Gerätes ;

Fig. 12 eine perspektivische Darstellung einer kompakten tragbaren Kontrollvorrichtung, die insbesondere für die Ueberprüfung von Freileitungen vom Boden aus geeignet ist ; und

Fig. 13 ein schematisches Blockschaltbild eines weiteren Ausführungsbeispiels der erfindungsgemässen Kontrollvorrichtung.

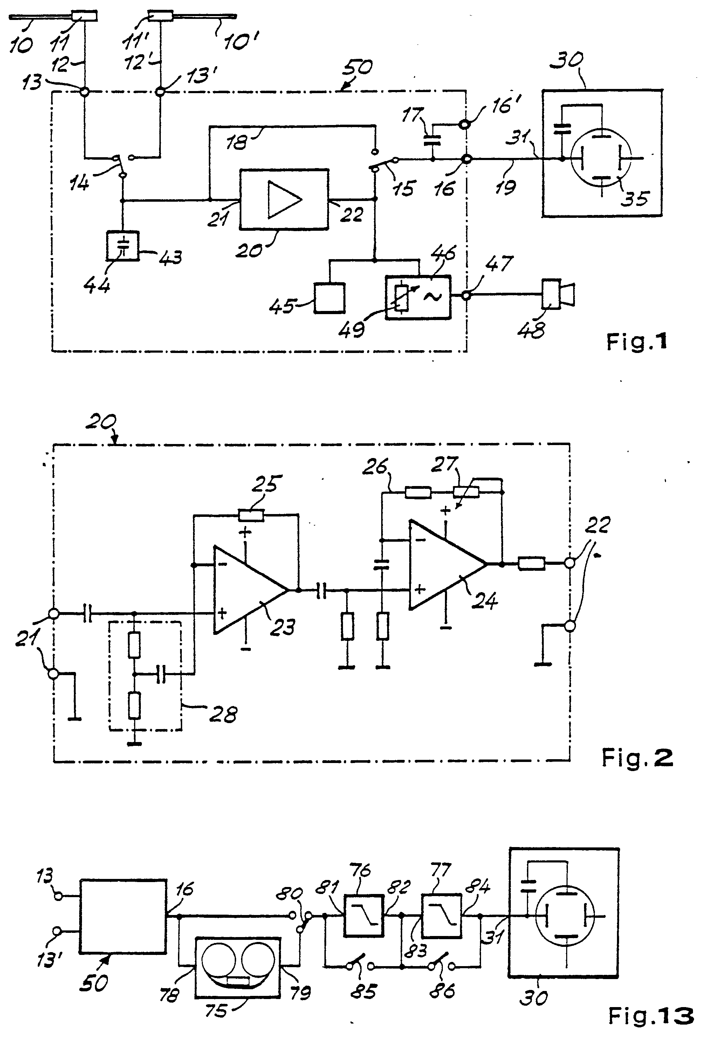

Gemäss dem in Fig. 1 ersichtlichen Schaltbild weist die Kontrollvorrichtung für die Detektion von Fehlstellen an Freileitungen als Hauptbestandteile eine Antenne 10, eine Verstärkereinrichtung 20 und ein Oszilloskop 30 auf. Die Antenne 10 ist mit einer Haltevorrichtung 11 versehen, mit deren Hilfe die Antenne z. B. an der linken Aussenseite der Flugzeugkanzel eines Hubschraubers befestigbar ist. Mit Vorteil kann auch eine zweite Antenne 10' vorhanden sein, die mittels einer zugehörigen Haltevorrichtung 11' an der gegenüberliegenden Aussenseite der Flugzeugkanzel anbringbar ist. Mittels abgeschirmter Antennenkabel 12 und 12' sind die Antennen 10 und 10' mit Anschlüssen 13 und 13' lösbar verbunden. Ein manuell zu betätigender Umschalter 14 gestattet, wahlweise die eine oder die andere Antenne 10 bzw. 10' an einen Signaleingang 21 der Verstärkereinrichtung 20 anzuschliessen. Letztere weist einen Signalausgang 22 auf, der mittels eines manuell zu betätigenden Schalters 15 mit einem Ausgangsanschluss 16 verbindbar ist. Ueber einen Kondensator 17 mit geringer Kapazität, z. B. 220 pF, ist der Ausgangsanschluss 16 mit einem zweiten Ausgangsanschluss 16' verbunden. Durch Umlegen des Schalters 15 lässt sich der Ausgangsanschluss 16 vom Signalausgang 22 der Verstärkereinrichtung 20 abtrennen und über einen By-pass-Leiter 18 unmittelbar mit dem Antennen-Umschalter 14 verbinden. Das Oszilloskop 30 weist einen Signaleingang 31 auf, der mittels eines abgeschirmten Kabels 19 wahlweise mit dem einen oder anderen der Ausgangsanschlüsse 16 und 16' verbindbar ist.

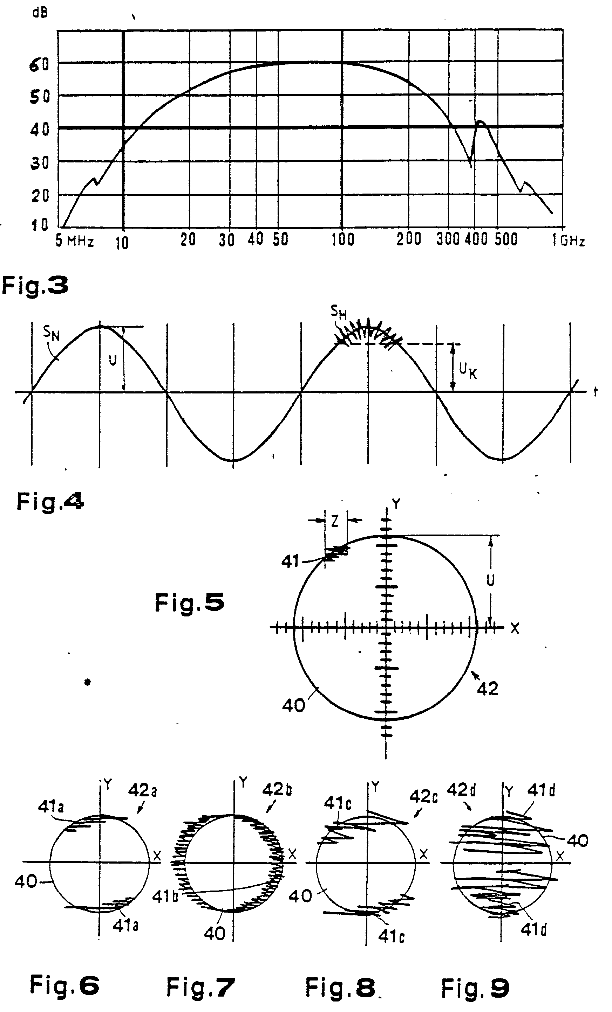

Ein Beispiel für die Schaltungsanordnung der Verstärkereinrichtung 20 ist in Fig. 2 dargestellt. Es ist ersichtlich, dass zwei integrierte Operationsverstärker 23 und 24 in Kaskade geschaltet sind und jeder dieser Operationsverstärker einen Gegenkopplungspfad 25 bzw. 26 vom Ausgang zum invertierenden Eingang aufweist. Im Gegenkopplungspfad 26 des zweiten Operationsverstärkers 24 befindet sich ein veränderbarer Widerstand 27 zum Einstellen des Verstärkungsgrades. Die Verstärkereinrichtung 20 ist imstande, Signale in einem breiten Frequenzband von einer unterhalb der Netz-Wechselstromfrequenz liegenden unteren Grenzfrequenz bis hinauf zu einer zwischen 200 MHz und etwa 1 GHz liegenden oberen Grenzfrequenz zu verstärken. Im Frequenzbereich von 5 MHz bis zur oberen Grenzfrequenz beträgt die Verstärkung mindestens 10 dB und im Ultrakurzwellenbereich, d. h. im Frequenzbereich von 30 MHz bis 200 MHz, beträgt die Verstärkung 40 bis 60 dB, wenn mittels des veränderbaren Widerstandes 27 der maximale Verstärkungsgrad eingestellt ist. Eine mit dem ersten Operationsverstärker 23 verbundene Widerstands-Kondensator-Kombination 28 hat die Aufgabe, die Verstärkung von Signalfrequenzen unterhalb etwa 10 kHz zu reduzieren. Der Verlauf der Verstärkung in Funktion der Signalfrequenz ist in Fig. 3 beispielsweise veranschaulicht.

Dem Oszilloskop 30, das ein handelsüblicher Typ für Batteriebetrieb sein kann, wird mittels des Kabels 19 das gesamte Frequenzspektrum der Ausgangssignale der Verstärkereinrichtung 20 zugeführt, und zwar sowohl für die horizontale oder X-Ablenkung als auch für die vertikale oder Y-Ablenkung des Bildpunktes auf dem Bildschirm 35. Demzufolge wird ein sinusförmiges Signal $S_N$ mit Netzfrequenz als geschlossene glatte Kurve 40 (Fig. 5) auf dem Bildschirm dargestellt. Bei korrekter Einstellung der X- und Y-Ablenkungen ist die Kurve 40 ein Kreis. Von Fehlstellen an der zu prüfenden Freileitung herrührende hochfrequente Signale $S_H$ werden auf dem Bildschirm des Oszilloskops 30 als Störungen 41 der geschlossenen glatten Kurve 40 wiedergegeben. Im allgemeinen haben die von den Fehlstellen einer Freileitung ausgehenden hochfrequenten Strahlungen beträchtlich geringere Amplituden als die von der niederfrequenten Wechselspannung auf der Freileitung ausgehende Strahlung. Da jedoch — wie erwähnt — die Verstärkereinrichtung 20 niederfrequente Signale unterhalb 10 kHz in geringerem Mass verstärkt als die hochfrequenten Signale, sind auf dem Bildschirm des Oszilloskops 30 die Amplituden der Störungen 41 im Vergleich zum Durchmesser der geschlossenen Kurve 40 vergrössert dargestellt und somit deutlich visuell wahrnehmbar. Durch die reduzierte Verstärkung von Signalen unterhalb 10 kHz werden in vorteilhafter Weise auch die gegebenenfalls vorhandenen harmonischen Oberwellen der Netzfrequenz auf dem Bildschirm des Oszilloskops 30 unterdrückt.

Bei der Ueberwachung einer Freileitung aus der Luft, insbesondere mit einem Hubschrauber, wird in einem seitlichen Abstand von 20 bis 30 m entlang der Freileitung geflogen, wobei die Antenne 10 oder 10' an der der Freileitung zugewandten Seite der Flugzeugkanzel angeschlossen ist. Die Umschaltbarkeit der Antennen 10 und 10' mittels des Schalters 14 ist vorteilhaft, weil hierdurch ermöglicht ist, immer auf der flugsichereren Seite der Freileitung zu fliegen und nie gegen die Sonne fliegen zu müssen.

Zur Erläuterung der Fehlstellenbestimmung zeigt Fig. 4 in einem Liniendiagramm schematisch auf einer Zeitskala t ein niederfrequentes Signal $S_N$ mit Netzfrequenz von 50 oder 60 Hz und ein hochfrequentes Signal $S_H$, wie sie von der Antenne 10 empfangen werden, wenn mit der beschriebenen Kontrollvorrichtung in der Freileitung eine Fehlstelle mit durch Koronaentladung verursachten Verlusten festgestellt wird. Bei ideal intakter Freileitung ergibt das empfangene niederfrequente Signal $S_N$ eine glatte Sinuslinie, deren Scheitelwert U der Amplitude der Wechselspannung auf der Freileitung proportional ist. Wenn an der erfassten Stelle Koronaentladungen auftreten, wird der glatte Verlauf der Sinuslinie für das niederfrequente Signal $S_N$ durch überlagerte Schwingungen eines hochfrequenten Signals $S_H$ gestört. Da die Koronaentladungen oberhalb einer bestimmten Anfangsspannung auftreten, ist nur der Scheitelbereich der Sinuslinie von der Störung betroffen, wobei die Höhe des Einsatzpunktes $U_K$ des hochfrequenten Signals $S_H$ der Anfangsspannung der Koronaentladungen entspricht. Die Schwingungsamplituden des hochfrequenten Signals $S_H$ ermöglichen Rückschlüsse auf die Stärke der an der Fehlstelle auftretenden Koronaentladungen und über diese auf die Beschaffenheit der Fehlstelle. Das in Fig. 4 gezeigte hochfrequente Signal $S_H$ ist durch positive Koronaentladungen verursacht, bei negativen Koronsentladungen würde die Störung auf der negativen Halbwelle des niederfrequenten Signals $S_N$ auftreten.

Fig. 5 zeigt in schematischer Darstellung ein mit der Kontrollvorrichtung nach der Erfindung auf dem eine X- und eine Y-Skala aufweisenden Oszilloskop-Bildschirm aufgezeichnetes Oszillogramm 42, bei dem auf der geschlossenen Kurve 40 für das niederfrequente Signal eine durch ein hochfrequentes Signal verursachte Störung 41 aufliegt. Aus dem Verhältnis der Amplitude U der geschlossenen Kurve 40 (Kreisradius) zur Amplitude Z der Störung 41 kann die Grösse der an einer so erfassten Fehlstelle auftretenden Verluste ermittelt werden. Für die Ermittlung von Verlusten werden zweckmässig Tabellen zusammengestellt, die ein schnelles Auswerten der bei einer Ueberwachung erhaltenen Oszillogramme gestatten.

Es hat sich gezeigt, dass für jede Fehlstellenart eine typische Störung 41 erhalten wird und so bei dem für eine Fehlstelle aufgezeichneten Oszillogramm aus der Erscheinungsform der Störung 41, ihrer Lage auf der geschlossenen Kurve 40 und ihrer Stärke eindeutig die Art der jeweils vorliegenden Fehlstelle festgestellt werden kann. Beispiele hierfür sind in den Fig. 6 bis 9 aufgezeigt.

Bei dem Oszillogramm 42a der Fig. 6 sind in den positiven und negativen Scheitelbereichen der geschlossenen Kurve 40 Störungen 41a vorhanden, deren Amplituden zum Kurvenscheitel hin zunehmen. Ein solches Oszillogramm zeigt Koronaentladungen an einem Isolator der Freileitung an.

Das Oszillogramm 42b der Fig. 7 zeigt über die geschlossene Kurve 40 gleichmässig verteilte Störungen 41b, die alle angenähert gleiche Amplitude haben. Solche Störungen 41b sind für einen korrodierten Teil der Freileitung typisch.

Bei mechanisch beschädigten Freileitungsteilen, wie Isolatoren, Klemmen usw., ist, wie Fig. 8 zeigt, die geschlossene Kurve 40 des Oszillogramms 42c im positiven und im negativen Bereich durch je eine Störung 41c mit spitzen Zacken überdeckt, deren Amplituden und Anzahl mit grösser werdender Beschädigung zunimmt, und bei einem sich daraus entwickelnden Kurzschluss füllen solche zackenartigen Störungen 41d den ganzen von der geschlossenen Kurve 40 umschlossenen Bereich aus, wie es in dem Oszillogramm 42d der Fig. 9 dargestellt ist, das somit einen Kurzschluss in der Freileitung anzeigt.

Wenn in der zu prüfenden Freileitung ein erheblicher Phasenunterschied zwischen dem Strom und der Spannung vorhanden ist, kann eine Verzerrung der von der niederfrequenten Signalkomponente herrührenden geschlossenen Kurve 40 auftreten. Solche Verzerrungen lassen sich durch eine Phasenschiebereinrichtung 43 beseitigen, die gemäss Fig. 1 an den Signaleingang 21 der Verstärkereinrichtung 20 angeschlossen ist und z. B. mindestens einen Kondensator 44 aufweist. Gegebenenfalls kann die Phasenschiebereinrichtung 43 an- und abschaltbar sein und/oder einen veränderbaren elektrischen Bauteil oder mehrere umschaltbare elektrische Bauteile, wie Kondensatoren, enthalten. Zweckmässig weist die Phasenschiebereinrichtung 43 zumindest einen zwischen Masse und den Eingang 21 der Verstärkereinrichtung eingeschalteten Kondensator auf.

Wie ebenfalls in Fig. 1 gezeigt ist, steht der Signalausgang 22 der Verstärkereinrichtung 20 auch mit einer optoelektronischen Anzeigevorrichtung 45 in Verbindung, die z. B. eine Zeile von lichtemittierenden Dioden oder eine entsprechende Flüssigkristallanzeige enthalten kann und die jeweilige Amplitude des Ausgangssignals der Verstärkereinrichtung 20, insbesondere der hochfrequenten Störsignale, visuell erkennen lässt. Weiter ist gemäss Fig. 1 an den Signalausgang 22 der Verstärkereinrichtung 20 auch eine elektronische Schaltungsanordnung 46 zum Erzeugen eines tonfrequenten Audiosignals angeschlossen, das einem Ausgangsanschluss 47 zugeführt ist. An letzterem ist ein Kopfhörer 48 oder die Bordtelefonanlage des Flugzeuges anschliessbar. Die Schaltungsanordnung 46 ist derart ausgebildet, dass sie beim Auftreten von hochfrequenten Störsignalen ein hörbares Tonfrequenz- oder Audiosignal erzeugt. Ferner kann die Schaltungsanordnung 46 einen spannungsgesteuerten Tonfrequenzoszillator enthalten, der ein Audiosignal erzeugt, dessen Frequenz eine Funktion der jeweiligen Amplitude der Hüllkurve der hochfrequenten Störsignale $S_H$ ist. Schliesslich kann mit Vorteil die Schaltungsanordnung 46 auch einen Schwellenwertdetektor enthalten, so dass das Audiosignal jeweils erst dann auftritt, wenn die Amplituden der Störsignale einen bestimmten Schwellenwert übersteigen. Es können Einstellmittel, z. B. in Form eines Potentiometers 49, vorhanden sein, um den Schwellenwert manuell verändern zu können.

Mit der beschriebenen Kontrollvorrichtung nach der Erfindung können praktisch alle bei Freileitungen vorkommenden Fehlstellen erfasst und bewertet werden, und zwar nicht nur Fehlstellen an und in den Leitungen und Isolatoren, insbesondere auch nichtdurchschlagbaren Isolatoren, sondern auch bei den angeschlossenen Einrichtungen, wie Transformatoren, Kondensatoren usw. Ausser den Hochspannungsleitungen können mit der Kontrollvorrichtung nach der Erfindung auch andere Freileitungen, insbesondere Starkstromleitungen für elektrische Bahnen, auf Fehlstellen überwacht werden. Durch rein fachmännische Aenderungen in der Schaltungsanordnung und/oder konstruktive Aenderungen ist die Kontrollvorrichtung dem jeweiligen Zweck optimal anpassbar. Gegebenenfalls können Fehlstellen von Freileitungen mit der Kontrollvorrichtung auch dann ermittelt werden, wenn die obere Grenzfrequenz der Verstärkereinrichtungen lediglich mindestens 20 kHz beträgt.

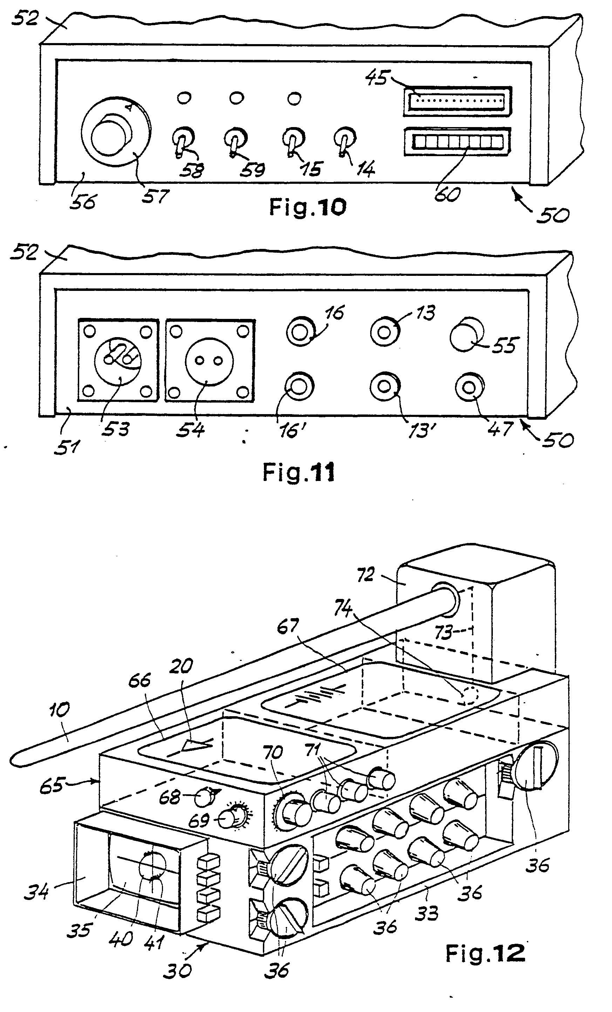

Für den Einsatz der Kontrollvorrichtung in Flugzeugen ist es zweckmässig, wesentliche Teile der Vorrichtung, ausser dem Oszilloskop 30, zu einem kompakten Gerät 50 zusammenzubauen, wie es beispielsweise in den Fig. 10 und 11 veranschaulicht und in Fig. 1 mit strichpunktierten Linien ebenfalls angedeutet ist. Gemäss Fig. 11 ist an der Rückwand 51 eines Gehäuses 52 ein Gerätestecker 53 zum Anschliessen des Bordnetzes des Flugzeuges oder einer anderen Gleichstromquelle mit einer Spannung von z. B. 24 V befestigt. Ebenso befindet sich an der Rückwand 51 eine Steckdose 54 für die Entnahme des Speisestromes für das Oszilloskop 30. Weiter findet man an der Rückwand 51 die beiden bereits erwähnten Anschlüsse 16 und 16' für das Signalkabel zum Oszilloskop 30 sowie die zwei Antennenanschlüsse 13 und 13'. Schliesslich sind an der Rückwand 51 noch der Ausgangsanschluss 47 für das Audiosignal und ein Betätigungsknopf 55 zum Ein- und Ausschalten der Tonfrequenz-Schaltungsanordnung 46 und zum Einstellen des Potentiometers 49 auf den gewünschten Schwellenwert für das Audiosignal angeordnet.

Gemäss Fig. 10 weist die Vorderwand 56 des Gehäuses 52 die folgenden Bauteile auf : Einen Drehknopf 57 zum Einstellen des veränderbaren Widerstandes 27 (Fig. 2) für die Verstärkungsregulierung, einen Hauptschalter 58 zum Ein- und Ausschalten der elektrischen Energiezufuhr über den Gerätestecker 53, einen Schalter 59 zum Ein- und Ausschalten der elektrischen Energiezufuhr zur Steckdose 54 für den Anschluss des Oszilloskops 30, die Umschalter 14 und 15 (Fig. 1), die optoelektronische Anzeigevorrichtung 45 (Fig. 1) und einen Betriebsstundenzähler 60, der jeweils läuft, solange der Hauptschalter 58 eingeschaltet ist. Der Umschalter 15 kann zweckmässig mit einem zusätzlichen (nicht dargestellten) Schalter zum Ein- und Ausschalten der Energiezufuhr zur Verstärkereinrichtung 20 mechanisch gekuppelt sein, so dass die Verstärkereinrichtung jeweils nur dann eingeschaltet ist, wenn mittels des Umschalters 15 der Ausgangsanschluss 16 mit dem Signalausgang 22 der Verstärkereinrichtung 20 verbunden ist.

Im Innenraum des Gehäuses 52 befinden sich die Verstärkereinrichtung 20, die Phasenschiebereinrichtung 43, die Tonfrequenz-Schaltungsanordnung 46 (Fig. 1) und eine (nicht dargestellte) Schaltungsanordung zur Bildung, Siebung und gegebenenfalls Stabilisierung der für die Speisung der Operationsverstärker 23 und 24 (Fig. 2), der optoelektronischen Anzeigevorrichtung 45 und der Tonfrequenz-Schaltungsanordnung 46 (Fig. 1) benötigten elektrischen Spannungen, wobei der Eingang dieser Speise-Schaltungsanordnung über den Hauptschalter 58 an den Gerätestecker 53 angeschlossen ist.

Für die Bodenüberwachung von Freileitungen ist es vorteilhaft, die ganze Kontrollvorrichtung gemäss der Erfindung als kompaktes, tragbares Gerät auszubilden, das ein Kontrolleur mittels eines Schulterriemens auf sich tragen und leicht bedienen kann. Ein Ausführungsbeispiel für ein derartiges Gerät ist in Fig. 12 dargestellt und nachstehend beschrieben. Als mechanisches Basisbauteil des Gerätes dient ein im Handel erhältliches, batteriebetriebenes Oszilloskop 30, wie z. B. ein « Tektronix Dual-Trace-Oszilloscope 214 ». Dieses Oszilloskop hat ein quaderförmiges flaches Gehäuse 33, bei dem der von einer Sonnenblende 34 umgebene Oszilloskop-Bildschirm 35 an einer Gehäuseschmalseite und die Bedienungsorgane 36 an einer Gehäuselängsseite angeordnet sind. Oben auf dem Gehäuse 33 des Oszilloskops 30 ist ein flaches Zusatzgehäuse 65 befestigt, das ein Abteil 66 zur Aufnahme der Verstärkereinrichtung 20 (Fig. 1) und ein weiteres Abteil 67 aufweist, in welchem Batterien und gegebenenfalls zugehörige Schaltungsanordnungen für die elektrische Speisung der Verstärkereinrichtung 20 und — soweit erforderlich — auch des Oszilloskops 30 untergebracht sind. Aussen am Zusatzgehäuse 65 sind Drehknöpfe 68, 69 und 70 für die Bedienung und Regulierung der Verstärkereinrichtung 20 und der Phasenschiebereinrichtung 43 (Fig. 1) sowie Druckknöpfe 71 zum Betätigen von Schaltern zum Ein- und Ausschalten und zum Umschalten von Stromkreisen angeordnet. Dei dieser tragbaren Ausführungsform der Kontrollvorrichtung wird nur eine einzige Antenne 10 benötigt. Diese ist vorzugsweise eine im Handel erhältliche Antivibrationsantenne, die an einem Zwischengehäuse 72 befestigt ist, welches seinerseits mittels Steckverbindungen an der rückseitigen Schmalseite des Zusatzgehäuses 65 lösbar montiert ist. Ueber einen der genannten Steckverbinder wird die elektrische Verbindung zwischen einem Antennenkabel 73 und einem mit dem Signaleingang 21 (Fig. 1) der Verstärkereinrichtung 20 verbundenen Antennenanschluss 74 erstellt. Wie in Fig. 12 ersichtlich, ist die Antenne 10 derart angeordnet, dass sie sich in einigem Abstand entlang dem Zusatzgehäuse 65 erstreckt und weder die Bedienung der Kontrollvorrichtung noch die Sicht auf den Oszilloskop-Bildschirm 35 stört. Das Zwischengehäuse 72 ist auf nicht näher dargestellte Weise so ausgebildet, dass es mittels Steckverbindern auch die nötigen elektrischen Verbindungen zwischen dem Signalausgang der Verstärkereinrichtung 20 und den Signaleingängen des Oszilloskops 30 für die X- und die Y-Ablenkung des Bildpunktes herstellt.

In Fig. 13 ist das Blockschaltbild einer Ausführungsvariante der mit Bezug auf Fig. 1 beschriebenen Kontrollvorrichtung dargestellt, wobei die gleichen Bezugszeichen benutzt sind, soweit Uebereinstimmung besteht. Man erkennt in Fig. 13 wieder die mit den zwei Antennenanschlüssen 13 und 13' sowie mit dem Signalausgang 16 versehene Schaltungsanordnung 50 und das den Signaleingang 31 aufweisende Oszilloskop 30. Im Gegensatz zum Ausführungsbeispiel nach Fig. 1 sind der Signalausgang 16 und der Signaleingang 31 nicht mehr direkt miteinander verbunden, sondern es sind ein Magnetband-Aufnahme- und -Wiedergabegerät 75 und zwei Tiefpassfilter 76 und 77 in Reihe dazwischengeschaltet. Das Magnetbandgerät 75 weist einen mit dem Signalausgang 16 der Schaltungsanordnung 50 verbundenen Eingang 78 für die auf Magnetband aufzuzeichnenden elektrischen Signale sowie einen Ausgang 79 für die vom Magnetband abgelesenen Signale auf. Mittels eines willkürlich betätigbaren Umschalters 80 kann man wahlweise den Ausgang 79 oder den Eingang 78 des Magnetbandgerätes 75 mit dem Signaleingang 81 des ersten Tiefpassfilters 76 verbinden. Der Ausgang 82 des ersten Tiefpassfilters 76 ist mit dem Eingang 83 des zweiten Tiefpassfilters 77 verbunden, dessen Ausgang 84 an den Signaleingang 31 des Oszilloskops 30 angeschlossen ist. Zwei willkürlich betätigbare Schalter 85 und 86 erlauben, wahlweise das eine oder andere oder beide Tiefpassfilter 76 und 77 zu überbrücken und damit auszuschalten. Durch das erste Tiefpassfilter 76 werden Signale mit Frequenzen oberhalb z. B. 20 kHz gedämpft oder unterdrückt, während durch das zweite Tiefpassfilter 77 Signale mit Frequenzen oberhalb z. B. 15 kHz gedämpft oder unterdrückt werden.

Die Gebrauchsweise der Kontrollvorrichtung nach Fig. 13 unterscheidet sich von jener der Kontrollvorrichtung nach Fig. 1 lediglich wie folgt : Die Bedienungsperson kann mittels des Magnetbandgerätes 75 die Ausgangssignale der Schaltungsanordnung 50 auf ein Magnetband aufzeichnen, soweit der Aufzeichnungs- und Wiedergabebereich des Gerätes 75 frequenzmässig reicht. Je nach der Stellung des Umschalters 80 kann man auf dem Bildschirm des Oszilloskops 30 wahlweise die von der Schaltungsanordnung 50 gelieferten Empfangssignale oder die auf Magnetband aufgezeichneten Signale sichtbar machen. Dies erlaubt Wiederholungen und nachträgliche Beobachtungen und Analysen von gegebenenfalls festgestellten Störungen auf dem Bildschirm des Oszilloskops. Durch Oeffnen des Schalters 85 oder 86 lässt sich das Tiefpassfilter 76 bzw. 77 einschalten, um gegebenenfalls die visuelle Beobachtung störende Hochfrequenzsignale zu unterdrücken, die z. B. von einem Radio- oder Fernsehsender stammen oder durch atmosphärische Störungen oder durch thermisches Rauschen hervorgerufen werden.

**Patentansprüche**

1. Kontrollvorrichtung zur elektronischen Detektion von bei Wechselstrom-Freileitungsnetzen vorkommenden Fehlstellen, an denen Energieverluste durch Koronaentladungen auftreten, mit einer Antenne (10 ; 10') für den Empfang von bei den Koronaentladungen auftretenden hochfrequenten Signalen ($S_H$), einer an die Antenne (10 ; 10') angeschlossenen Verstärkereinrichtung (20) zur Verstärkung der empfangenen Signale ($S_N$ und $S_H$) und einem Oszilloskop (30) zur visuellen Anzeige von empfangenen Signalen, dadurch gekennzeichnet, dass die Verstärkereinrichtung (20) für eine Breitbandverstärkung von mittels der Antenne (10 ; 10') empfangenen Signalen in einem Frequenzband von einer unterhalb der niederfrequenten Netz-Wechselstromfrequenz liegenden unteren Grenzfrequenz bis hinauf zu einer mindestens 20 kHz betragenden oberen Grenzfrequenz ausgebildet ist, wobei im Bereich zwischen der unteren Grenzfrequenz und etwa 10 kHz die Verstärkung reduziert ist, dass das gesamte Frequenzspektrum der Ausgangssignale der Verstärkereinrichtung (20) an eine Eingangsschaltung des Oszilloskops (30) für Vertikal- und Horizontalablenkungen des Bildpunktes geführt ist, so dass auf dem Bildschirm (35) des Oszilloskops (30) ein von der sinusförmigen Netz-Wechselspannung auf der Freileitung erzeugtes niederfrequentes Signal ($S_N$) als eine glatte, geschlossene Kurve (40) und die durch die Koronaentladungen verursachten hochfrequenten Signale ($S_H$) als Störungen (41) der geschlossenen Kurve (40) dargestellt sind, wobei die Erscheinungsform der Störungen (41), deren Stärke und Lage auf der geschlossenen Kurve (40) den Ort und die Art einer Fehlstelle der Freileitung erkennen lassen.

2. Vorrichtung nach Anspruch 1, dadurch gekennzeichnet, dass die obere Grenzfrequenz der Verstärkereinrichtung (20) zwischen 200 MHz und 1 GHz liegt, und im Bereich von 20 bis 200 MHz die Verstärkung mindestens 40 dB beträgt.

3. Vorrichtung nach Anspruch 1 oder 2, dadurch gekennzeichnet, dass zwischen der Verstärkereinrichtung (20) und dem Oszilloskop (30) mindestens ein wahlweise ein- und ausschaltbares Tiefpassfilter (76 ; 77) angeordnet ist.

4. Vorrichtung nach einem der Ansprüche 1 bis 3, dadurch gekennzeichnet, dass an den Signaleingang (21) der Verstärkereinrichtung (20) eine Phasenschiebereinrichtung (43) mit wenigstens einem Kondensator (44) angeschlossen ist zur Kompensation von bei dem empfangenen niederfrequenten Signal ($S_N$) auftretenden Phasenverschiebungen, welche die Anzeige auf dem Oszilloskop-Bildschirm (35) als glatte geschlossene Kurve (40) verzerren.

5. Vorrichtung nach Anspruch 4, dadurch gekennzeichnet, dass die den Kondensator (44) enthaltende Phasenschiebereinrichtung (43) mittels eines manuell betätigbaren Bedienungsknopfes (70) verstellbar ist.

6. Vorrichtung nach einem der Ansprüche 1 bis 5, dadurch gekennzeichnet, dass das Gerät zwei Antennen-Anschlüsse (13, 13') und einen Umschalter (14) aufweist zum wahlweisen Verbinden des einen oder anderen Antennen-Anschlusses mit dem Eingang der Verstärkereinrichtung (20), und dass für eine Ueberwachung von Freileitungen aus der Luft mittels eines Flugzeuges, insbesondere eines Hubschraubers, zwei Antennen (10, 10') vorhanden sind, die zum Befestigen an der linken bzw. rechten Seite des Flugzeuges ausgebildet und je mittels eines abgeschirmten Kabels (12, 12') mit einem der Antennen-Anschlüsse (13, 13') verbindbar sind.

7. Vorrichtung nach einem der Ansprüche 1 bis 6, dadurch gekennzeichnet, dass an den Ausgang (22) der Verstärkereinrichtung (20) eine optoelektronische Signalpegel-Anzeigevorrichtung (45) angeschlossen ist.

8. Vorrichtung nach einem der Ansprüche 1 bis 7, dadurch gekennzeichnet, dass der Ausgang (22) der Verstärkereinrichtung (20) mit einer Tonfrequenz-Schaltungsanordnung (46) mit einem Anschluss (47) für einen elektroakustischen Signalgeber (48) verbunden ist.

9. Vorrichtung nach Anspruch 8, dadurch gekennzeichnet, dass die Tonfrequenz-Schaltungsanordnung (46) Mittel zum Unterdrücken von Signalen, deren Amplituden kleiner als ein gegebener, vorzugsweise einstellbarer Schwellenwert sind, aufweist.

10. Vorrichtung nach Anspruch 8 oder 9, dadurch gekennzeichnet, dass die Tonfrequenz-Schaltungsanordnung (46) Mittel zum Erzeugen eines Tonfrequenzsignals, dessen Frequenz abhängig ist von der Amplitude der empfangenen hochfrequenten Signale (S$_H$), aufweist.

11. Vorrichtung nach einem der Ansprüche 1 bis 10, dadurch gekennzeichnet, dass zumindest die Verstärkereinrichtung (20) und eine Stromversorgungseinrichtung zu einem kompakten Gerät (50) vereinigt sind, das wenigstens einen mit einem Eingang (21) der Verstärkereinrichtung (20) verbundenen Anschluss (13) zum Anschliessen der Antenne (10) und vorzugsweise auch einen Betriebsstundenzähler (60) aufweist.

**Claims**

1. Control apparatus for the electronic detection of faults arising in alternating current overhead transmission lines at which power losses arise through corona discharges, with an antenna (10 ; 10') for the reception of high frequency signals (S$_H$) arising by said corona discharges, an amplifying device (20) connected to the antenna (10 ; 10') for amplifying the received signals (S$_N$ and S$_H$) and an oscilloscope (30) for the visual indication of the received signals, characterised in that the amplifier device (20) is constructed for broad amplification of signals received by means of the antenna (10 ; 10') in a frequency range from a lower limiting frequency lying below the low frequency alternating current line frequency to an upper limiting frequency of at least 20 kHZ, where in a range between the lower limiting frequency and approximately 10 kHZ the gain of the amplifying device is reduced ; in that the entire frequency spectrum of the output signals of the amplifier device (20) is fed to an input circuit of the oscilloscope (30) for vertical and horizontal deflection of the image spot so that on the image screen (35) of the oscilloscope (30) a low frequency signal (S$_N$) produced by the sinusoidal alternating line voltage on the overhead transmission line appears as a smooth closed curve (40) and the high frequency signals (S$_H$) caused by the corona discharges appear as disturbances (41) of the closed curve (40), whereby the appearance of the disturbances, their magnitude and position on the closed curve enable to recognize the location and type of a fault on the overhead transmission line.

2. Apparatus according to claim 1, characterised in that the upper limiting frequency of the amplifying device (20) is between 200 MHz and 1 GHz, and in that the gain is at least 40 dB in the range of 20 to 200 MHz.

3. Apparatus according to claim 1 or 2, characterised in that at least one low-pass filter (76 ; 77) is provided, which is selectively switchable into the circuit between the amplifying device (20) and the oscilloscope (30).

4. Apparatus according to any one of claims 1 to 3, characterised in that a phase-shifting device (43) with at least one capacitor (44) is connected at the signal input (21) of the amplifying device (20), for the compensation of phase displacements arising in the received low frequency signal (S$_N$), which phase displacements distort the smooth closed curve (40) indicated on the oscilloscope image screen (35).

5. Apparatus according to claim 4, characterised in that the phase shifting device (43) containing the capacitor (44) is adjustable by means of a manually actuatable service knob (70).

6. Apparatus according to any one of claims 1 to 5, characterised in that it comprises two antenna terminals (13, 13') and a change-over switch (14) for the selectable connection of the one or other antenna terminal with the input of the amplifying device (20) ; and that for monitoring of overhead transmission lines from the air by means of an aircraft, particularly a helicopter, two antennas (10, 10') are present which are arranged for being secured to the left and right sides of the aircraft and each of which is connectable by means of a shielded cable (12, 12') with one of the antenna terminals (13, 13').

7. Apparatus according to any one of claims 1 to 6, characterised in that an opto-electronic signal level indicating device (45) is connected to the output (22) of the amplifying device (20).

8. Apparatus according to any one of claims 1 to 7, characterised in that the output (22) of the amplifying device (20) is connected with an audio frequency circuit arrangement (46) having a terminal (47) for connecting an electro-acoustic signal emitting device (48).

9. Apparatus according to claim 8, characterised in that the audio frequency circuit arrangement (46) comprises means for suppressing signals with amplitudes smaller than a predetermined and preferably adjustable threshold value.

10. Apparatus according to claim 8 or 9, characterised in that the audio frequency circuit arrangement (46) comprises means for producing an audio frequency signal, the frequency of which is dependent on the amplitude of the received high frequency signals (S$_H$).

11. Apparatus according to any one of claims 1 to 10, characterised in that at least the amplifying device (20) and a current supply unit are combined together into a compact instrument (50) which comprises at least one terminal (13) connected with an input (21) of the amplifying device (20), for connection of the antenna (10), and preferably also an elapsed time counter (60).

## Revendications

1. Dispositif de contrôle pour la détection électronique de défauts apparaissant dans des lignes de transmission aériennes à courant alternatif auxquelles se produisent des pertes d'énergie causées par des décharges en couronne, avec une antenne (10 ; 10') pour la réception de signaux à haute fréquence ($S_H$) se produisant lors desdites décharges en couronne, un dispositif amplificateur (20) raccordé à l'antenne (10, 10') pour amplifier les signaux reçus ($S_N$ et $S_H$) et un oscilloscope (30) pour l'indication visuelle des signaux reçus, caractérisé en ce que le dispositif amplificateur (20) est construit pour une amplification à large bande de signaux reçus au moyen de l'antenne (10 ; 10') dans une bande de fréquences entre une fréquence limite inférieure se situant en dessous de la fréquence de la ligne à courant alternatif à basse fréquence et une fréquence limite supérieure d'au moins 20 kHz, le gain d'amplification étant réduit dans la bande entre la fréquence limite inférieure et approximativement 10 kHz ; et en ce que le spectre de fréquence entier des signaux de sortie du dispositif amplificateur (20) est introduit dans un circuit d'entrée de l'oscilloscope (30) pour une déflexion verticale et horizontale du point d'image de manière à ce qu'un signal basse fréquence ($S_N$) produit par la tension alternative sinusoïdale de la ligne sur la ligne aérienne apparaisse sur l'écran (35) de l'oscilloscope (30) sous forme d'une courbe douce fermée (40) et que les signaux de haute fréquence ($S_H$) causés par les décharges en couronne apparaissent comme dérangements (41) de la courbe fermée (40), l'apparence des dérangements, leur grandeur et position sur la courbe fermée permettant de reconnaître la position et le type du défaut sur la ligne de transmission aérienne.

2. Dispositif selon la revendication 1, caractérisé en ce que la fréquence limite supérieure du dispositif amplificateur (20) est entre 200 MHz et 1 GHz, et en ce que le gain est au moins 40 dB dans la bande de 20 à 200 MHz.

3. Dispositif selon la revendication 1 ou 2, caractérisé en ce qu'il est prévu au moins un filtre passe-bas (76 ; 77) qui peut être à volonté branché ou débranché du circuit entre le dispositif amplificateur (20) et l'oscilloscope (30).

4. Dispositif selon l'une quelconque des revendications 1 à 3, caractérisé en ce qu'un dispositif de déphasage (43) avec au moins un condensateur (44) est raccordé à l'entrée de signaux (21) du dispositif amplificateur (20) pour compenser des décalages de phase apparaissant dans le signal à basse fréquence ($S_N$) reçu, ces décalages de phase défigurant la courbe douce fermée (40) représentée sur l'écran (35) de l'oscilloscope.

5. Dispositif selon la revendication 4, caractérisé en ce que le dispositif de déphasage (43) contenant le condensateur (44) est ajustable au moyen d'un bouton (70) à commande manuelle.

6. Dispositif selon l'une quelconque des revendications 1 à 5, caractérisé en ce qu'il comprend deux raccords d'antenne (13, 13') et un commutateur (14) pour la connexion à volonté de l'un ou l'autre des raccords d'antenne avec l'entrée du dispositif amplificateur (20), et en ce que pour la surveillance des lignes de transmission aériennes de l'air au moyen d'un avion, en particulier d'un hélicoptère, sont prévues deux antennes (10, 10') construites pour être montées sur le côté gauche respectivement droit de l'avion et qui peuvent être raccordées chacune au moyen d'un câble écranné (12, 12') à l'un des raccords d'antenne (13, 13,).

7. Dispositif selon l'une des revendications 1 à 6, caractérisé en ce qu'un appareil indicateur de niveau de signaux opto-électronique (45) est branché à la sortie (22) du dispositif amplificateur (20).

8. Dispositif selon l'une des revendications 1 à 7, caractérisé en ce que la sortie (22) du dispositif amplificateur (20) est connectée avec un circuit d'audiofréquence (46) ayant un raccord pour un transmetteur de signaux électroacoustiques (48).

9. Dispositif selon la revendication 8, caractérisé en ce que le circuit d'audiofréquence (46) comprend des moyens pour supprimer des signaux ayant des amplitudes plus petites qu'une valeur de seuil prédéterminé, de préférence réglable.

10. Dispositif selon la revendication 8 ou 9, caractérisé en ce que le circuit d'audiofréquence (46) comprend des moyens pour produire un signal d'audiofréquence dont la fréquence dépend de l'amplitude des signaux à haute fréquence ($S_H$) reçus.

11. Dispositif selon l'une des revendications 1 à 10, caractérisé en ce qu'au moins le dispositif d'amplification (20) et une unité de source de courant sont combinés pour former un instrument compact (50) comprenant au moins un raccord (13) connecté avec une entrée (21) du dispositif d'amplification (20) pour brancher l'antenne (10), ainsi que, de préférence, également un totalisateur d'heures de marche (60).

Fig.1

Fig.2

Fig.13

Fig.3

Fig.4

Fig.5

Fig.6     Fig.7     Fig.8.     Fig.9

Fig.10

Fig.11

Fig.12